# EUROPEAN PATENT APPLICATION

(11) **EP 4 776 003 A1**
(43) Date of publication of application: **15.07.2026**
(21) Application number: 25151806.4
(22) Date of filing: 14.01.2025
(51) Int. Cl.: G01R 29/18, G01R 31/67

(54) **METHOD OF OPERATING AN ELECTRICAL DEVICE**

(71) Applicant: Viessmann Holding International GmbH, 35108 Allendorf (Eder) (DE)
(72) Inventor: KISNER, Viktor, 13353 Berlin (DE); KMIEC, Robert, 56-400 Olesnica (PL); PRITZKOLEIT, Max, 13347 Berlin (DE)
(74) Representative: FDST Patentanwälte

(57) **Abstract**

The invention relates to a method (32) for operating an electrical device (18) which has a plurality of phase connections (20) for connection to a respective phase (20) of a house connection (6). A respective first phase current (36) conducted via each phase connection (20) is detected, and a respective second phase current (30) conducted via each of each phase (10) of the house installation (4) is detected. A "changepoint detection" is carried out for each first phase current (36), so that respective first time points (40) are determined for each first phase current (36). A "changepoint detection" is performed for each second phase current (20), so that respective second time points (42) are determined for each second phase current (20). A confidence for the assignment of one of the phase connections (20) to one of the phases (10) is increased if a corresponding second time point (42) for this phase (10) is present for one of the first time points (40) for this phase connection (20). The invention also relates to an electrical device (18) and a house installation (4).

## Description

The invention relates to a method for operating an electrical device and an electrical device. The electrical device has a plurality of phase connections for connection to a respective phase of a house connection. The invention also relates to a house installation.

Buildings usually have a house installation with several loads. These are usually electrically connected to a house connection by means of a respective electrical cable, via which electrical energy is fed into the respective building. For this purpose, the house connection is electrically connected to a supply network, via each of which a three-phase alternating voltage is usually conducted. The house connection therefore also has three phases. The electrical voltage conducted by each of the phases is sinusoidal, with an offset of 120° between the individual phases. For safety reasons, each phase of the house connection is protected by an associated fuse and/or circuit breaker. If a fault occurs in one of the phases, such as a short circuit, and the electrical current conducted by this phase exceeds a threshold value for some time, the fuse/circuit breaker is tripped and the supply of current to this phase from the supply network is terminated.

If the house installation also includes an electrical device that is also an (electrical) load and has an increased power requirement, this is electrically connected to all phases of the house connection. For this purpose, the electrical device has three phase connections. Despite the increased power requirement in normal operation, i.e. when there is no fault such as a short circuit, the fuse/circuit breaker should be prevented from tripping. For this purpose, it is known to limit the electrical current currently drawn via the house connection. As the house installation has several loads, it is possible that, by chance, those currently in operation are electrically connected to the same phase. Therefore, the electrical current drawn via each phase is limited to the difference between the threshold value and the electrical current currently conducted via the house connection, which corresponds to the sum of the electrical current drawn by the other loads. In this way, unwanted tripping of the fuse/circuit breaker is reliably avoided, even if all other loads are only electrically connected to one of the phases. As this is usually not the case, the electrical current drawn by the electrical device is excessively limited, which reduces its performance

To remedy this, the electrical current conducted per phase is therefore usually determined by an energy meter and the difference between the threshold value applicable to the respective phase and the electrical current conducted with this phase is determined. The electrical current can then be drawn for the respective phase up to this difference. However, this requires a direct assignment of each phase of the house connection to one of the phase connections of the electrical device. This is done, for example, when the electrical device is first installed. For this purpose, the electrical cables conducted between the electrical device and the house connection are measured, but this is only possible in a de-energized state and requires special tools. However, if the electrical device is designed as a wallbox, the phases used to charge the vehicle change, namely depending on the vehicle being charged.

The invention is based on the task of providing a particularly suitable method for operating an electrical device and a particularly suitable electrical device as well as a particularly suitable house installation, whereby performance and/or safety is advantageously increased, and whereby installation effort is reduced.

With regard to the method, this task is solved in accordance with the invention by the features of claim 1, with regard to the electrical device by the features of claim 9 and with regard to the house installation by the features of claim 10. Advantageous further developments and embodiments are the subject of the respective subclaims.

The method is used to operate an electrical device. The electrical device is suitable, in particular intended and arranged to form part of a house installation. Suitably, the electrical device is thus intended to be installed in a building, for example in a private household or in a commercial/office unit. In particular, the electrical device has a comparatively high power requirement, at least during peak operation. For example, the maximum electrical power drawn is greater than 2 kW, 3 kW, 4 kW, 5 kW or 10 kW. Suitably, the maximum electrical power drawn is less than 50 kW, 22 kW or 11 kW.

For example, the electrical device is an instantaneous water heater and thus forms part of a (hot) water supply. Alternatively, the electrical device is a wallbox and is used to charge electric vehicles. In another alternative, the electrical device is a component of a heating system and is, for example, an electric heater or, particularly preferably, a heat pump.

To supply the electrical device, it has several phase connections for connection to one phase of a house connection in each case. The house connection therefore has at least as many phases as the electrical device has phase connections. In particular, there are exactly 3 phase connections/3 phases. A time-varying electrical potential is conveniently conducted via each of the electrical phases. In particular, this is sinusoidal and has a specific frequency and amplitude. Preferably, the frequency is 50 Hz or 60 Hz, and the amplitude is 230 V or 110 V. In particular, the frequency and/or amplitude of the respective electrical potentials is the same, but they are shifted relative to each other so that a phase angle of 120° is formed between them. In particular, the house connection also has a reference potential, for example earth/ground. The house connection, which is also referred to as the supply connection or "point of common coupling" (PCC), conveniently represents the connection of the house installation to an (external) supply network, by means of which the 3 electrical potentials and/or earth/ground are preferably provided.

In the installed state, each phase connection of the electrical device is connected to one of the phases of the house connection and thus electrically contacted with it. Several separate cables are used for this purpose, for example, or preferably one cable, which preferably comprises several cores. Each core is assigned to one of the phase connections and one of the phases. The phase connections are provided, for example, by means of a common plug, terminals or cable lugs.

The method provides for a respective first phase current conducted via each of the phase connections to be detected. The first phase currents are in particular dependent on a current operation of the electrical device and therefore on a current power consumption. Consequently, the first phase currents change in particular as a function of a current power supplied by the electrical device. Each of the first phase currents thus represents a time series. Conveniently, the electrical device has three phase connections, which is why three different first phase currents are detected.

Suitably, the first phase currents are measured and the electrical device has corresponding sensors for this purpose. Suitably, the sensors assigned to the respective phase connections are identical in design, which is why manufacturing costs are reduced. In particular, each phase connection is assigned a corresponding current sensor, which is designed to be contactless, for example, and comprises a Hall sensor. However, a shunt comprising a measuring resistor is particularly preferred. To determine the first phase currents, the electrical voltage across the respective measuring resistor is measured and the respective first phase current is derived from this.

In addition, a respective second phase current conducted via each phase of the house installation is detected. For example, the electrical device has a corresponding additional sensor for this purpose, which is arranged in the area of the house installation. However, it is particularly preferred that the house installation, for example the house connection, has corresponding current sensors by means of which the second phase currents can be measured. The current sensors are expediently provided by means of a respective electricity meter, which is used, for example, for billing the electrical power drawn from any supply network. This means that existing components can be used and no additional components are required, which reduces manufacturing costs. To detect the second phase currents by the electrical device, the measured second phase currents are conveniently transmitted to the electrical device using signal technology. In particular, the electrical device is thus connected to the house connection and/or the electricity meters using signal technology. In summary, the second phase currents are thus detected by receiving corresponding data. Suitably, the house connection has three phases, which is why a total of three different second phase currents are detected. The second phase currents also change over time, in particular depending on the electrical power drawn from or fed into the supply network. Each second phase current therefore corresponds to a time series.

In particular, the first and second phase currents are detected over a common time period. A "changepoint detection" is carried out for each first phase current. In other words, an abrupt change in the respective time series is determined. Preferably, several such changes are determined for each first phase current. For each change, the time at which it occurred is determined and used as the respective first time point. If there are therefore several changes in the respective first phase current, there are several corresponding first time points, whereas if there is no corresponding change, there is no first time point. In summary, the "changepoint detection" is thus carried out for each first phase current, so that the respective first time points are determined for each first phase current. In other words, each first time point corresponds to the time point at which a corresponding change in the respective first phase current occurred, which is determined using the "changepoint detection".

In addition, a "changepoint detection" is carried out for each second phase current, so that second time points are determined for each second phase current. For example, the second time points are determined using a different procedure/algorithm to the first time points. However, it is particularly preferred that these are determined in the same way as the first time points, whereby the second phase currents are used instead of the first phase currents in the algorithm used.

In a further step, a confidence for the assignment of one of the phase connections to one of the phases is changed. For example, when the method is carried out for the first time, no confidence is yet available and this is then created. Alternatively, for example, a predefined confidence is already available when the procedure is carried out for the first time, which is then changed and which is, for example, 0% or 50% or corresponds to this.

The confidence for the assignment of one of the phase connections to one of the phases is increased if there is a corresponding second time point for this phase for one of the first time points for this phase connection. In other words, it is first determined that the corresponding second time point is present for one of the first time points. Then it is checked which of the first phase currents is assigned to the first time point and which phase connection is assigned to this first phase current. Similarly, a check is made for the second time point to determine which of the second phase currents and therefore which of the phases corresponds to it. The confidence for the assignment of this phase connection to this phase is then increased. If there are therefore three phase connections and three phases, there are a total of nine corresponding assignments, namely for each of the phase connections to each of the phases.

The method therefore makes it possible to determine the assignment of the phase connections to the phases. It is not necessary to de-energize the corresponding electrical line(s) by means of which the phase connections are connected to the phases and/or to use special tools. Instead, this is done, for example, using the current sensors already present in the electrical device and/or an existing electricity meter in the house installation. This means, for example, that no or only comparatively inexpensive components are required, which reduces costs. Also, no specialist knowledge is required to determine the assignment, which simplifies installation and reduces installation work. In particular, it is not necessary to pay attention to a specific/predefined connection of the phase connections to specific electrical lines/wires when installing the electrical device.

After completion of the method, or at least if the confidence is comparatively high, it is also possible to operate the electrical device depending on the assignment, so that, for example, an overload of the house installation is avoided. In particular, unintentional/unwanted triggering/tripping of a safety device of the house installation, in particular of the house connection, such as a fuse or a circuit breaker, is avoided. For example, depending on the confidence of the assignment, the electrical power drawn by the electrical device is suitably distributed to the phase connections/phases. This makes it possible, for example, to equalize load distribution based on the confidence. Furthermore, if, for example, an (electrical) power generator is available, such as a photovoltaic system, which is also electrically connected to the house connection, it is possible to use the electrical energy provided by this in a targeted manner, for which electrical energy is predominantly drawn via the phase connection assigned to this phase.

By the method, the confidence is increased if the corresponding second time point is present for one of the first time points. In other words, the increase occurs as a function of the first time points that are caused by a change in the operation of the electrical device and are thus also reflected in a change in one of the second phase currents. On the other hand, it is possible for second time points to occur that are not caused by a change in the operation of the electrical device, but rather, for example, by a change in the operation of a load that is also electrically connected to the house connection. Since the first time points are used, the effort is reduced. In other words, all first time points are checked, but not, for example, all second time points that are present and whose number is greater than that of the first time points.

Conveniently, the electrical device has a control unit by means of which the method is at least partially carried out. Here, the control unit is used, for example, only to carry out the method, or also for other operation of the electrical device, in particular depending on external requirements. In other words, an actuator or another function of the electrical device is controlled and/or regulated by means of the control unit. In particular, depending on present requirements, such as a heat requirement.

To create the time points, i.e. for "changepoint detection", for example, the time series representing the respective phase currents are divided into several time windows, which are preferably of equal length. In particular, the length is between 0.5 seconds and 10 seconds. However, sliding time windows are particularly preferred. This prevents, for example, a change that occurs at the same time as the transition between two time windows from being ignored. For example, the time windows used to determine the second time points are the same length as the time windows that are also used for the first time points. Alternatively, they may be different. For example, the time windows used for the first phase currents are in particular shortened and/or adapted to any current sensors that the electrical device has. This increases accuracy. Also, no additional components are required if the current sensors are also used to control the electrical device. In particular, the time windows are between 0.2 seconds and 2 seconds and preferably equal to 1 second.

To determine the second phase currents, it is advisable to use an electricity meter(s), which are preferably already available. However, these have a comparatively low time resolution, for example. For this reason, the time windows used for changepoint detection are extended. This means that no additional components are required, which reduces manufacturing costs. In particular, the time windows are between 2 seconds and 8 seconds long and suitably 4 seconds long. In another embodiment, the time windows are between 0.2 seconds and 4 seconds long and suitably 1 seconds long.

For example, to determine the time points, a method described in " Aminikhanghahi S, Cook DJ. A Survey of Methods for Time Series Change Point Detection. Knowl Inf Syst. 2017 May;51(2):339-367. doi: 10.1007/s10115-016-0987-z. Epub 2016 Sep 8. PMID: 28603327; PMCID: PMC5464762" is used. A "CUSUM" algorithm is particularly preferred for determining the time points, i.e. for "changepoint detection", which is described in "E. S. Page: Continuous Inspection Schemes. In: Biometrika. Band 41, Nr. 1/2, Juni 1954, ISSN 0006-3444, S. 100-115, JSTOR:2333009" and "G. A. Barnard: Control Charts and Stochastic Processes. In: Journal of the Royal Statistical Society. Series B (Methodological). Band 21, Nr. 2, 1959, ISSN 0035-9246, S. 239-271, JSTOR:2983801". By using theses algorithms, it possible to determine the time points with comparatively few resources. As a result, it is possible to design the possible control unit of the electrical device to be low-power and therefore cost-effective. In particular, an "embedded system" is used as the control unit.

For example, the confidence is also increased depending on other conditions/characteristics. In particular, the confidence is increased if an increase in the respective phase current has a certain amplitude at the respective time point and/or the deviation between the amplitudes of the changes is smaller than a certain limit value. However, it is particularly preferred that only the time points are used to increase the confidence, which is why less effort is required. For example, there is a functional relationship between the increase in confidence and the characteristics of the first phase current and/or the second phase current at the respective time point. However, it is particularly preferable to increase the confidence by increasing a counter associated with this assignment, preferably always by the same value. The counter is in particular an integer, which is why memory requirements for the control unit are reduced. Due to the use of the counter alone, hardware requirements are thus further reduced and a comparatively complicated determination of the confidence is not necessary.

For example, the counter is used directly as the confidence level. If the counter therefore has a comparatively high value, the confidence is high. However, it is particularly preferable to divide the counter by the number of first time points assigned to the respective phase connection to determine the confidence. The counter is thus weighted. If there are therefore many corresponding first and second time points due to noise or similar, this is taken into account. For example, the quotient is used directly as confidence and thus corresponds in particular to the proportion of first time points that correspond to the second time points of the respective phases. Alternatively, further processing is also carried out so that, for example, comparability is ensured. Alternatively, or in combination with this, other requirements/ circumstances are also taken into account, for example.

It is particularly preferable to check for each first time point whether a corresponding second time point exists/is present. This makes it easier to implement the method using software or hardware, and a loop is used in particular for this purpose. For example, it is also checked for each second time point whether a corresponding first time point exists/is present. Thereby, it is also possible for the same second time point to be assigned to different first time points. This can occur if two of the first phase currents change at the same time and/or the length of the time windows used for "changepoint detection" are of different lengths. However, it is particularly preferable not to check whether there is a corresponding first time point for every second time point, as the second time points can also result from a change in the operation of another load in the house installation. Thus, an effort is reduced and a time required to carry out the method is reduced.

For example, a correlation analysis is carried out to check whether the first time points corresponds to the second time points. However, it is particularly preferable to determine the time interval between these. The first time point corresponds to the second time point if the time interval between them is less than a limit value. The limit value is preferably less than 10 seconds, 5 seconds or 3 seconds. Suitably, the limit value is greater than 0.5 seconds, 1 second or 2 seconds. Thus, even with a comparatively poor temporal resolution of the phase currents, a comparatively accurate determination is possible as to whether the time points correspond to each other / are caused by the same change in the operation of the electrical device. It is necessary, for example, that the first time point always occurs before the second time point or vice versa. However, it is particularly preferable that the time interval are used without a sign. As a result, any inductances or the like of the house installation are taken into account, which can lead to a shift in the time points where these are nevertheless caused by the same change in the operation of the electrical device.

For example, the method is carried out until it is ended manually by a user. Here, for example, the confidence for the different assignments is output. However, it is particularly preferable for the assignment to be stored if the assigned confidence is greater than a threshold value. This corresponds in particular to a value between 60 % and 100 % and, for example, between 70 % and 80 %. Suitably, the threshold value corresponds to 75%. As a result, the time until the storing is made is comparatively short, although it can be assumed that the assignment is essentially correct. After the storing, the confidence in particular is not changed any further and in particular no more "changepoint detection" is carried out. This reduces the effort involved. As soon as the assignment has been stored, it can be used for other purposes, for example transmitted to other components of the house installation or at least made available for retrieval. It is also possible to control other functions of the electrical device depending on the stored assignment.

For example, once the assignment has been stored, no further action is taken with regard to the assignment. However, it is particularly preferable to check the plausibility of the stored assignment. In particular, a suitable algorithm is used for this, which preferably deviates from "changepoint detection". Preferably, a correlation analysis is carried out to check plausibility. For this purpose, the correlation coefficient is calculated in particular for the respective phase currents of the respective stored assignment. The assignment is only plausibilized if the correlation coefficient is greater than a correspondingly assigned further threshold value. If the plausibility check is not successful, for example, the method is carried out again, i.e. the first and second time points are determined again. In particular, other time windows are used for this. Preferably, the assignment is only used if the plausibility check was successful. This increases the probability that the stored assignment is correct.

Preferably, the first phase current conducted via the respective phase connection is limited based on the stored assignment. For this purpose, the second phase currents in particular continue to be detected by means of the electrical device and the difference to a threshold value assigned to the respective phases is determined, which is determined in particular on the basis of any fuse device/safety device. The electrical current conducted via this phase connection can then be increased by the amount of this difference. For example, an increase by the amount or only by the amount reduced by a safety margin is carried out. This makes it possible to operate the electrical device with a comparatively high power without overloading the house connection and/or triggering/tripping any safety device, such as a fuse/circuit breaker.

In particular, before the assignment is stored, the first phase currents are also limited, for example to a fixed value or one that is dependent on the second phase currents. In particular, the maximum of the second phase currents is determined and the limitation takes place depending on this and any threshold value. This also ensures that any safety device is not triggered, which is why the availability of the electrical device is increased. Therefore, the maximum power is comparatively high, but lower than if the stored assignment is used. In addition, the safety device is always reliably triggered /tripped in the event of a fault, which increases safety.

The electrical device has several phase connections for connection to one phase of a house connection in each case. Preferably, the electrical device comprises exactly three phase connections, and/or the phase connections are incorporated in a housing of the electrical device. The electrical device is operated according to a method in which a respective first phase current conducted via each phase connection is detected, and in which a respective second phase current conducted via each phase of the house installation is detected. A "changepoint detection" is carried out for each first phase current, so that respective first time points are determined for each first phase current. A "changepoint detection" is carried out for each second phase current so that respective second time points are determined for each second phase current. A confidence for the assignment of one of the phase connections to one of the phases is increased if a corresponding second time point for this phase is present for one of the first time points for this phase connection.

In particular, the electrical device has current sensors by means of which the first phase currents can be measured. Preferably, the electrical device has an interface for signal coupling with one or more (external) electricity meters, by means of which the second phase currents are measured. Detecting then takes place by receiving the second phase currents via the interface. The interface is suitable for wired communication, for example, and is provided and set up for this purpose. Alternatively or in combination with this, the interfaces are suitable for communication in accordance with a mobile, WLAN and/or Bluetooth standard and are provided and set up for this purpose.

In particular, the electrical device has a control unit that is intended and set up to carry out the method. The control unit comprises, for example, an application-specific integrated circuit (ASIC) or, particularly preferably, a computer which is suitably designed to be programmable. In particular, the control unit comprises a storage medium on which a computer program product, also referred to as a computer program, is stored, wherein upon execution of this computer program product, i.e. the program, the computer is caused to perform the method. The control unit doesn't have to be on the electrical device, but it can be in another device or in a separate box. In another embodiment, the control unit is at least partially provided by means of a server. The invention further relates to such a control unit, such a computer program product and a storage medium on which the computer program product is stored. Such a storage medium is, for example, a CD-ROM, a DVD or a Blu-Ray disc. Alternatively, the storage medium is a USB stick or other storage device that is, for example, rewritable or can only be written to once. Such a memory is, for example, a flash memory, a RAM or a ROM.

The house installation has a house connection with several phases. The house connection is preferably suitable, in particular designed to be connected to a supply network. In particular, the number of phases is equal to 3. The house installation also has an electric meter / electricity meter / energy meter assigned to each of the phases. By means of the electricity meter, it is possible to measure a respective second phase current conducted by each of the phases. In particular, the electricity meter has several appropriately designed sensors for this purpose, each of which is assigned to one of the phases. For example, the sensors are arranged in different housings of the electricity meter or preferably in a common housing. The electricity meter is, for example, a component of the house connection or a separate device.

The house installation further comprises an electrical device having a plurality of phase connections for connection to one of the phases of the house connection at a time. Each phase connection is electrically contacted with one of the phases. In particular, an electrical wiring is used for this purpose. Conveniently, electrical contact is made by means of an electrical cable which has a plurality of cores, with one of the cores being assigned to each phase.

The electrical device is also connected to the electricity meter via a signal line. This enables the transmission of signals/data between the electricity meter and the electrical device. This enables communication between them, whereby the communication complies with a bus standard in particular.

The electrical device is operated according to a method in which a respective first phase current conducted via each phase connection is detected, and in which a respective second phase current conducted via each phase of the house installation is detected. A "changepoint detection" is carried out for each first phase current, so that respective first time points are determined for each first phase current. A "changepoint detection" is carried out for each second phase current so that respective second time points are determined for each second phase current. A confidence for the assignment of one of the phase connections to one of the phases is increased if a corresponding second time point for this phase is present for one of the first time points for this phase connection.

The house installation is conveniently operated in accordance with a method for operating the house installation. In the method for operating the house installation, the method for operating the electrical device is carried out. The second phase currents are measured by means of the electricity meter. These are then transmitted to the electrical device so that the second phase currents are detected by means of the electrical device.

The further embodiments and advantages explained in connection with the method for operating the electrical device are also to be applied mutatis mutandis to the electrical device / the control unit / the computer program product / the storage medium / the house installation / the method for operating the house installation and to each other, and vice versa.

In the following, an embodiment of the invention is explained in more detail with reference to a drawing. It shows:
- Fig. 1: schematic of a building with a house installation comprising a house connection and an electrical device,
- Fig. 2: a method for operating the house installation, comprising a method for operating the electrical device,
- Fig. 3: the time course of a phase current, and
- Fig. 4: several first and second time points.

Corresponding parts are marked with the same reference signs in all figures.

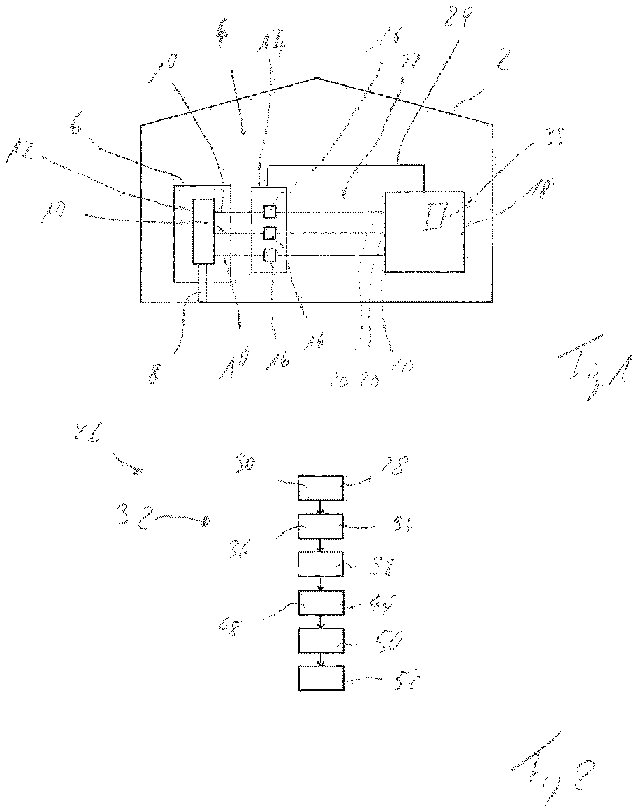

Figure 1 schematically shows a building 2, which is a private household. The building 2 has a house installation 4 with a house connection 6, which is also referred to as a PCC. This is connected to a supply line 8 of a supply network, by means of which a three-phase alternating voltage is conducted. Each of the phases has a time-varying electrical potential with a sinusoidal curve. The level of the electrical voltage is 230 V in each case and the frequency is 50 Hz. The three phases are 120° out of phase with each other.

The house connection 6 also has three phases 10, one of which corresponds to each of the phases of the supply network. Thus, the sinusoidal alternating electrical voltage is also conducted via each of the phases 10 of the house connection 6.

The house connection 6 has a safety device 12, which comprises several fuses not shown in detail, one of which is assigned to each of the phases 10. The fuses are electrically connected between each of the phases 10 of the house connection 6 and the phases of the supply network. If an excessive electrical current, for example greater than 63A, is conducted via the phases 10 of the house connection 6, the fuse assigned to the respective phase 10 is triggered/tripped so that the electrical current is interrupted. With such a high electrical current, serious injury to persons and/or damage to the devices to which it is applied is possible.

The house installation 4 comprises an electricity meter 14, which is electrically downstream of the house connection 6, so that there are no other devices electrically between the electricity meter 14 and the house connection 6. In a variant not shown in detail, the electricity meter 14 is integrated into the house connection 6. The electricity meter 14 has several sensors 16, each of which is assigned to one of the phases 10. The electricity meter 14 therefore has a total of three sensors 16. These are used to measure the electrical current drawn from the supply network via the respective phase 10 and, if applicable, fed into it and used for billing with a supply company.

An (electrical) distribution board, which is not shown in detail, is connected downstream of the electricity meter 14, to which (electrical) loads, which are not shown in detail, are electrically connected. It is therefore possible to supply the loads with electricity via the house connection 6. This means that only the sum of the electrical currents conducted to the loads can be measured using the electricity meter 14.

The house installation 4 also has an electrical device 18, which has a comparatively high power requirement. In this variant, the electrical device 18 is designed as a heat pump. The electrical device 18 has three phase connections 20, each of which is electrically contacted with one of the phases 10 of the house connection 6. An electrical cable 22 is used for this purpose, which has several cores. The electrical contact is made via the electricity meter 14, so that the power drawn by the electrical device 18 can also be measured by means of the electricity meter 14.

In addition, the electrical device 18 is connected to the electricity meter 14 by means of a signal line 24. This enables communication between them, for which a bus system is formed. In summary, the house installation 4 thus has the house connection 6 with the three phases 10. Thus, the house installation 4 has the electricity meter 14 associated with each of the phases 10 and the electrical device 18, which has the three phase connections 20. Each phase connection 20 is electrically connected to one of the phases 10, and the electrical device 18 is connected to the electricity meter 14 in terms of signal technology.

The house installation 4 is operated in accordance with a method 26 shown in Figure 2 for operating the house installation 4. In this, in a first step 28, a respective second phase current 30 conducted via each of the phases 10 is measured by means of the electricity meter 14, for which the sensors 16 are used. Consequently, a total of three time series are created, each of which corresponds to one of the second phase currents 30. The measured second phase currents 30, i.e. the time series, are fed into the signal line 24 and thus provided.

In the following, a method 32 for operating the electrical device 18 is carried out. To carry out the method 32 for operating the electrical device 18, the electrical device 18 has a control unit 33. In the method 32 for operating the electrical device 18, a second working step 34 is first carried out, which is thus carried out after the first working step 28 of the method 26 for operating the house installation 4 and represents the first working step of the method 32 for operating the electrical device 18.

In the second step 34, the second phase currents 30 are detected, namely queried by the electricity meter 14 via the signal line 24. In summary, the respective second phase current 30 conducted via each phase 10 of the house installation 4 is detected. In addition, a respective first phase current 36 conducted via each phase connection 20 is detected. These are measured by means of current sensors not shown in detail and installed in the electrical device 18. The detected first phase currents 36 are also used for the control of the electrical device 18. In summary, there are three time series, one of which corresponds in each case to one of the second phase currents 30, and three time series, one of which corresponds in each case to one of the first phase currents 36.

In a third step 38, a "changepoint detection" is carried out for both the first phase currents 36 and the second phase currents 30. At such a changepoint, the course of the respective first phase current 36 or the second phase current 30 changes abruptly at a respective first or second time point 40, 42.

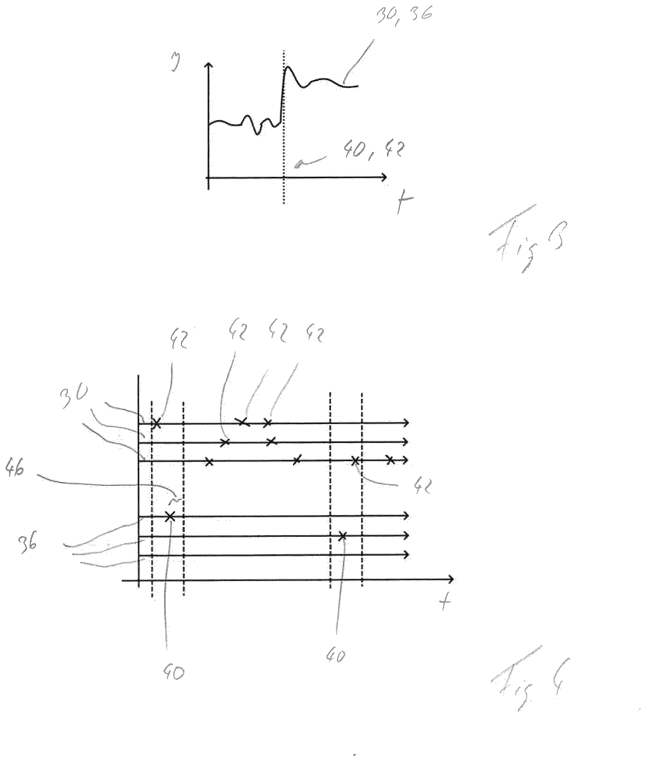

Figure 3 shows an example of this. The respective phase current 30, 36 increases abruptly at the corresponding time point 40, 42. A CUSUM-algorithm is used to perform the changepoint detection, by means of which the first and second time points 40, 42 are determined. In summary, the "changepoint detection" is thus carried out for each first phase current 36, so that the respective first time points 40 are determined for each first phase current 36. Changepoint detection is also performed for each of the second phase currents 30, so that the respective second time points 42 are determined for each second phase current 30.

Figure 4 shows an example of several such first and second time points 40, 42, whereby several corresponding second time points 42 are determined for each of the second phase currents 30. For two of the first phase currents 36, a corresponding first time point 40 is present in each case, whereas for one of the first phase currents 36, no corresponding first time point 40 could be determined.

In a subsequent fourth step 44, it is checked for each first time point 40 whether one of the second time points 42 corresponds, i.e. exists/is present. For this purpose, it is checked whether the time interval between the corresponding first time point 40 and the second time point 42 is less than a limit value 46. It is possible that the second time point 42 occurs before or after the corresponding first time point 40. In summary, it is thus checked whether a corresponding second time point 42 is present for each first time point 40.

If one of the second time points 42 corresponds to one of the first time points 40, it is checked which of the first phase currents 36 the first time point 40 is assigned to and which of the second phase currents 30 the corresponding second time point 42 is assigned to. For this pair, i.e. the assignment of one of the phase connections 20 to one of the phases 10, an associated counter 48 is then incremented.

Since there are three phases 10 and three phase connections 20, there are a total of 3 × 3 corresponding assignments. Of them only 6 variants are uses, as each of the second phase currents 30 must be one-to-one assigned to one of first the phase currents 36.

After checking whether a corresponding second time point 42 exists/is present for all first time points 40, the counters 48 are divided by the number of first time points 40 assigned to this phase connection 20. The resulting value is then used as the confidence. Consequently, the confidence for the assignment of one of the phase connections 20 to one of the phases 10 is increased if a corresponding second time point 42 for this phase 10 exists/is present for one of the first time points 40 for this phase connection 20.

In a subsequent fifth step 50, the corresponding assignment is stored in a memory not shown in detail, namely if the assigned confidence is greater than a threshold value, such as 75%. A plausibility check of the stored assignment is then carried out. For this purpose, the correlation coefficient between the first phase current 36 designated by the stored assignment and the corresponding second phase current 32 is created. Only if this is greater than a certain value, such as 0.75, is the assignment checked for plausibility. Otherwise, the method 26 for operating the house installation 4 is aborted and restarted.

After the plausibility check, a sixth step 52 is carried out. In this step, the first phase currents 36 conducted via the phase connections 20 are limited on the basis of the stored assignment. For this purpose, the second phase currents 20 are measured and compared with the configuration of the safety device 12. The limitation is selected in such a way that the electrical current conducted via the respective phase 10 /phase connection 20 is maximum, but the safety device 12 is not triggered/tripped.

The invention is not limited to the embodiment described above. Rather, other variants of the invention can also be derived from it by the person skilled in the art without departing from the object of the invention. In particular, all the individual features described in connection with the embodiment can also be combined with one another in other ways without departing from the object of the invention.

### List of reference symbols

- 2: Building
- 4: House installation
- 6: House connection
- 8: Supply line
- 10: Phase
- 12: Safety device
- 14: Electricity meter
- 16: Sensor
- 18: Electrical device
- 20: Phase connection
- 22: Electrical cable
- 24: Signal line
- 26: Methods for operating the house installation
- 28: First step
- 30: Second phase current
- 32: Method for operating an electrical device
- 33: Control unit
- 34: Second step
- 36: First phase current
- 38: Third step
- 40: First time point
- 42: Second time point
- 44: Fourth step
- 46: Limit value
- 48: Counter
- 50: Fifth step
- 52: Sixth step

## Claims

1. Method (32) for operating an electrical device (18) which has a plurality of phase connections (20) for connection to a respective phase (20) of a house connection (6),
- a respective first phase current (36) conducted via each phase connection (20) is detected,
- a respective second phase current (30) conducted via each of each phase (10) of the house installation (4) is detected,
- a changepoint detection is carried out for each first phase current (36), so that respective first time points (40) are determined for each first phase current (36),
- a changepoint detection is carried out for each second phase current (20), so that respective second time points (42) are determined for each second phase current (20),
- a confidence for the assignment of one of the phase connections (20) to one of the phases (10) is increased if a corresponding second time point (42) for this phase (10) is present for one of the first time points (40) for this phase connection (20).

2. Method (32) according to claim 1,
**characterized in that**
a counter (48) assigned to this phase connection (20) and this phase (10) is incremented.

3. Method (32) according to claim 2,
**characterized in that**
the counter (48) is divided by the number of first time points (40) assigned to this phase connection (20) in order to determine the confidence.

4. Method (32) according to any one of claims 1 to 3,
**characterized in that**
for each first time point (40) a check is made as to whether a corresponding second time point (42) exists.

5. Method (32) according to any one of claims 1 to 4,
**characterized in that**
the first time point (40) corresponds to the second time point (42) if a time interval between these is less than a limit value (46).

6. The method (32) according to any one of claims 1 to 5,
**characterized in that**
the assignment is stored if the assigned confidence is greater than a threshold value.

7. The method (32) according to claim 6,
**characterized in that**
the stored assignment is checked for plausibility.

8. Method (32) according to claim 6 or 7,
**characterized in that**
the first phase current (36) conducted via the respective phase connection (20) is limited on the basis of the deposit.

9. An electrical device (18) comprising a plurality of phase connections (20) for connection to a respective phase (10) of a house connection (6), and operated according to a method (32) according to any one of claims 1 to 8.

10. House installation (4), which has a house connection (6) with a plurality of phases (10), an electricity meter (14) assigned to each of the phases (10) and an electrical device (18) according to claim 9, wherein each phase connection (20) is electrically contacted with one of the phases (10), and wherein the electrical device (18) is connected to the electricity meter (14) in terms of signal technology.
